# EUROPÄISCHE PATENTANMELDUNG

(11) **EP 0 735 588 A1**
(43) Veröffentlichungstag der Anmeldung: **02.10.1996**
(21) Anmeldenummer: 96103573.0
(22) Anmeldetag: 07.03.1996
(51) Int. Cl.: H01L 27/12, H03K 17/10

(54) **Integrierte Schaltungsanordnung mit der Funktion eines symmetrisch sperrenden Triacs**

(30) Priorität: 31.03.1995 DE 19512257
(71) Anmelder: SIEMENS AKTIENGESELLSCHAFT, 80333 München (DE)
(72) Erfinder: Stoisiek, Michael, Dr., 85521 Ottobrunn (DE); Melbert, Joachim, Dr., 82041 Deisenhofen (DE)

(57) **Zusammenfassung**

Eine integrierte Schaltungsanordnung, die die Funktion eines symmetrisch sperrenden Triacs emuliert, umfaßt zwei Schaltungszweige (D4, T1, D1; D3, T1, D2), die parallel zwischen zwei Wechselspannungsanschlüssen (W1, W2) verschaltet sind und die jeweils mindestens eine Diode und ein asymmetrisch sperrendes, ansteuerbares Leistungsbauelement umfassen, wobei der Strom in der einen Halbwelle den einen Schaltungszweig und in der anderen Halbwelle den anderen Schaltungszweig durchfließt. Dabei durchfließt der Strom das ansteuerbare Leistungsbauelement in derjenigen Polung, in der das Leistungsbauelement die höhere Sperrfähigkeit aufweist.

## Beschreibung

Schaltbare Leistungshalbleiterbauelemente, die mit beliebiger Polarität der Spannung an den Hauptstromklemmen betreibbar sind, sind als Schalter in Wechselspannungsanwendungen, zum Beispiel bei Phasenanschnittssteuerungen zum direkten Betrieb an Netzwechselspannung oder bei SLIC-Bausteinen für Telekommunikationsvermittlungssysteme, geeignet. Derartige Bauelemente werden als bidirektional sperrende Leistungshalbleiterbauelemente bezeichnet.

Es ist bekannt, als bidirektional sperrendes Leistungshalbleiterbauelement einen Triac zu verwenden (siehe zum Beispiel J. D. Beamson: "High Voltage Dielectric Isolation SCR Integrated Circuit Process", IEEE 1977 Int. Electron Devices Meeting, p. 178 bis 180, 1977). In dem Triac sind zwei symmetrisch sperrende Thyristoren antiparallel verschaltet. Symmetrisch sperrende Thyristoren sind als diskrete Bauelemente erhältlich. In einem Substrat integrierte symmetrisch sperrende Thyristoren, die gegen das Substrat dielektrisch isoliert sind, weisen bei einer Wannentiefe von 30 µm, wie sie für integrierte Thyristoren üblich ist, eine Sperrfähigkeit von maximal 250 Volt auf. Eine höhere Sperrfähigkeit ist bei derartigen integrierten symmetrisch sperrenden Thyristoren mit einer drastischen Vergrößerung der Wannentiefe und damit erhöhtem Prozeßaufwand verbunden.

Der Erfindung liegt das Problem zugrunde, eine integrierte Schaltung mit der Funktion eines symmetrisch sperrenden Triacs anzugeben, bei der ohne zusätzlichen Prozeßaufwand eine erhöhte Sperrfähigkeit erzielbar ist.

Dieses Problem wird erfindungsgemäß gelöst durch eine integrierte Schaltungsanordnung gemäß Anspruch 1. Weitere Ausgestaltungen der Erfindung gehen aus den übrigen Ansprüchen hervor.

In der erfindungsgemäßen integrierten Schaltungsanordnung werden ein erster Schaltungszweig und ein zweiter Schaltungszweig jeweils zwischen zwei Wechselspannungsanschlüssen parallel verschaltet. Beide Schaltungszweige umfassen jeweils mindestens eine Diode und ein asymmetrisch sperrendes, ansteuerbares Leistungsbauelement. Als asymmetrisch sperrendes, ansteuerbares Leistungsbauelement wird ein ansteuerbares Leistungsbauelement bezeichnet, das je nach Polung eine unterschiedliche Sperrfähigkeit aufweist. Im leitenden Zustand des ansteuerbaren Leistungsbauelementes fließt der Strom in einer ersten Halbwelle der Wechselspannung über den ersten Schaltungszweig und in einer zweiten Halbwelle der Wechselspannung über den zweiten Schaltungszweig. Dabei ist das ansteuerbare Leistungsbauelement in beiden Halbwellen in der Richtung gepolt, in der es die höhere Sperrfähigkeit aufweist.

Als ansteuerbares Leistungsbauelement ist jedes Leistungsbauelement geeignet, das sich in dem Bereich der Stromspannungskennlinie, in dem Strom und Spannung größer Null sind, schalten läßt. Insbesondere kann als Leistungsbauelement ein Thyristor, ein GTO, ein IGBT oder ein DMOS-Transistor verwendet werden. Im Fall eines Thyristors, eines GTO's oder eines IGBT's fließt der Strom von der Anode zur Kathode des Bauelementes. Im Fall eines DMOS-Transistors fließt der Strom von Drain zu Source.

Asymmetrisch sperrende, ansteuerbare Leistungsbauelemente lassen sich insbesondere mit dielektrischer Isolation unter Verwendung des sogenannten Resurf-Prinzipes mit deutlich geringerer Wannentiefe und einer Sperrfähigkeit über 250 Volt realisieren. Bei einer Wannentiefe von zum Beispiel 20 um wird eine Vorwärtssperrfähigkeit von 600 Volt, eine Rückwärtssperrfähigkeit von 200 Volt bei Thyristoren erzielt. Als Resurf-Prinzip wird die Tatsache bezeichnet, daß, wenn im Isolationswannenbereich weniger als die zum Lawinendurchbruch im Silizium erforderliche Ladung vorhanden ist, bei sperrendem Zustand des Leistungsbauelementes ein Teil des elektrischen Feldes in das die Isolationswanne umgebende Oxid gedrängt wird.

Die erfindungsgemäße integrierte Schaltungsanordnung ist daher unter Verwendung asymmetrisch sperrender ansteuerbarer Leistungsbauelemente, zum Beispiel von Thyristoren, mit einer Sperrfähigkeit von zum Beispiel 600 Volt bei Verwendung eines SOI-Substrates, in dessen Siliziumschicht das Leistungsbauelement mit dielektrischer Isolation realisiert ist, herstellbar.

Gemaß einer ersten Ausführungsform der Erfindung umfaßt die Schaltungsanordnung vier Dioden, die nach Art eines Brückengleichrichters, auch Graetz-Brücke genannt, verschaltet sind. In die Brückendiagonale ist ein asymmetrisch sperrendes ansteuerbares Leistungsbauelement geschaltet. Im leitenden Zustand werden jeweils zwei Dioden und das ansteuerbare Leistungsbauelement vom Laststrom durchflossen. Der Laststrom fließt dabei in beiden Halbwellen in derselben Richtung durch das ansteuerbare Leistungsbauelement. Dagegen fließt der Laststrom in den beiden Halbwellen jeweils durch zwei unterschiedliche Dioden. Die Kathode bzw. der Sourceanschluß des ansteuerbaren Leistungsbauelementes liegt dabei vorzugsweise auf Substratpotential. Das Leistungsbauelement wird gegen Substratpotential angesteuert.

Gemaß einer anderen Ausführungsform umfaßt die Schaltungsanordnung zwei entgegengesetzt gepolte Anordnungen aus je einem asymmetrisch sperrenden ansteuerbaren Leistungsbauelement und einer dazu antiparallel verschalteten Diode. Parallel zu dieser Serienschaltung werden zwei entgegengesetzt gepolte, in Serie verschaltete Dioden geschaltet. Diese werden zur Festlegung des Substratpotentials benötigt. Im leitenden Zustand fließt der Laststrom in der einen Halbwelle jeweils durch die eine der Dioden und das eine Leistungsbauelement der Serienschaltung, in der anderen Halbwelle durch die andere Diode und das andere Leistungsbauelement. Die ansteuerbaren Leistungsbauelemente werden jeweils in derselben Polungsrichtung durchflossen. Kathode bzw. Sourceanschluß und Ansteuerung der ansteuerbaren Schaltelemente werden vorzugsweise auf ein beliebiges positives Potential gegenüber dem Substrat gelegt. In dieser Ausführungsform werden die parallel zur Serienschaltung vorgesehenen zusätzlichen Dioden zur Festlegung des Substratpotentials vom Laststrom nicht durchflossen. Sie können daher kleiner als die anderen Dioden dimensioniert werden. Ferner werden die ansteuerbaren Leistungsbauelemente jeweils nur in einer Halbwelle durchflossen, so daß die Leistungsaufnahme des einzelnen Leistungsbauelementes in der zweiten Ausführungsform geringer als in der ersten Ausführungsform ist. Auch die ansteuerbaren Leistungsbauelemente können daher in der zweiten Ausführungsform kleiner dimensioniert werden als in der ersten Ausführungsform. Daher ist die zweite Ausführungsform bezüglich des Chipflächenverbrauchs gegenüber der ersten Ausführungsform zu bevorzugen.

Die erste Ausführungsform hat gegenüber der zweiten Ausführungsform den Vorzug einer einfacheren, auf Substratpotential bezogenen Ansteuerung.

Im folgenden wird die Erfindung anhand von Ausführungsbeispielen und den Figuren näher erläutert. Die Darstellungen in den Figuren sind nicht maßstabsgetreu.
- Figur 1: stellt ein Schaltbild dar einer integrierten Schaltungsanordnung, die die Funktion eines symmetrisch sperrenden Triacs emuliert und die vier nach Art eines Brückengleichrichters verschaltete Dioden umfaßt, in dessen Brückendiagonale ein Thyristor verschaltet ist.
- Figur 2: zeigt eine Aufsicht auf eine integrierte Schaltungsanordnung gemäß dem in Figur 1 dargestellten Schaltbild.
- Figur 3: zeigt den in Figur 2 mit III-III bezeichneten Schnitt durch die Schaltungsanordnung. Der Schnitt ist in einem anderen Maßstab als die Aufsicht dargestellt.
- Figur 4: zeigt ein Schaltbild für eine integrierte Schaltungsanordnung, die die Funktion eines symmetrisch sperrenden Triacs emuliert und die eine Serienschaltung von zwei entgegengesetzt gepolten Anordnungen aus jeweils einem Thyristor und einer dazu antiparallel verschalteten Diode umfaßt.
- Figur 5: zeigt eine Aufsicht auf eine Schaltungsanordnung gemäß dem in Figur 4 dargestellten Schaltbild.
- Figur 6: zeigt den in Figur 5 mit VI-VI bezeichneten Schnitt. Der Schnitt ist in einem anderen Maßstab als die Aufsicht dargestellt.

Zwischen einen ersten Knoten K1, der mit Substratpotential verbunden ist, und einen ersten Wechselspannungsanschluß W1 ist eine erste Diode D1 so verschaltet, daß die Kathode der Diode D1 mit dem ersten Wechselspannungsanschluß W1 verbunden ist. Zwischen den ersten Knoten K1 und einen zweiten Wechselspannungsanschluß W2 ist eine zweite Diode D2 geschaltet, die entgegengesetzt gepolt zur ersten Diode D1 ist und deren Kathode mit dem zweiten Wechselspannungsanschluß W2 verbunden ist.

Zwischen den zweiten Wechselspannungsanschluß W2 und einen zweiten Knoten K2 ist eine vierte Diode D4 geschaltet, deren Kathode mit dem zweiten Knoten K2 verbunden ist. Zwischen den zweiten Knoten K2 und den ersten Wechselspannungsanschluß W1 ist eine dritte Diode D3 verschaltet, deren Kathode mit dem zweiten Knoten K2 verbunden ist und die somit entgegengesetzt gepolt zur vierten Diode D4 ist. Zwischen den ersten Knoten K1 und den zweiten Knoten K2 ist ein Thyristor T1 geschaltet. Die Kathode des Thyristors T1 ist mit dem ersten Knoten K1, die Anode des Thyristors T1 ist mit dem zweiten Knoten K2 verbunden. Der Thyristor T1 ist über eine Gateelektrode G1 ansteuerbar.

Im Betrieb der Schaltungsanordnung sind der erste Wechselspannungsanschluß W1 und der zweite Wechselspannungsanschluß W2 mit einer Wechselspannungsquelle verbunden. In einer der Wechselspannungsleitungen, zum Beispiel zwischen dem zweiten Wechselspannungsanschluß W2 und der Wechselspannungsquelle ist ein Verbraucher V1 geschaltet. Die Gateelektrode G1 wird über eine Ansteuerschaltung (der Übersichtlichkeit halber nicht dargestellt) angesteuert. Die Versorgungsspannung für die Ansteuerschaltung kann aus den Knoten K1 und K2 abgeleitet werden.

Der erste Knoten K1 ist mit dem Substratpotential verbunden, das der Punkt mit dem negativsten Potential der Schaltung ist.

Wird der Thyristor T1 über die Gateelektrode G1 so angesteuert, daß er leitet, so fließt ein Strom durch die Schaltungsanordnung. Wahrend einer ersten Halbwelle der Wechselspannung fließt der Strom über die vierte Diode D4, den Thyristor T1 und die erste Diode D1. Während einer zweiten Halbwelle der Wechselspannung fließt der Strom über die dritte Diode D3, den Thyristor T1 und die Diode D2. Die erste Diode D1, der Thyristor T1 und die vierte Diode D4 bilden einen ersten Schaltungszweig, die zweite Diode D2, der Thyristor T1 und die dritte Diode D3 bilden einen zweiten Schaltungszweig. Sowohl im ersten Schaltungszweig als auch im zweiten Schaltungszweig wird der Thyristor T1 von dem zweiten Knoten K2 zum ersten Knoten K1 durchflossen. In dieser Polungsrichtung weist der Thyristor T1 eine höhere Sperrfähigkeit auf als in der entgegengesetzten Polungsrichtung.

Da alle Dioden D1, D2, D3, D4 vom Laststrom durchflossen werden, müssen sie für den Laststrom dimensioniert werden. Der Thyristor T1 wird in beiden Halbwellen von Laststrom durchflossen und muß so dimensioniert werden, daß die dabei auftretende Leistung abgeführt werden kann. Vorzugsweise werden die Dioden D1, D2, D3, D4 so dimensioniert, daß sie der Verlustleistungsbeanspruchung durch jede zweite Wechselstromhalbwelle standhalten. Der Thyristor T1 wird so dimensioniert, daß er der Verlustleistungsbeanspruchung standhält, die bei Stromfluß während jeder Wechselstromhalbwelle entsteht.

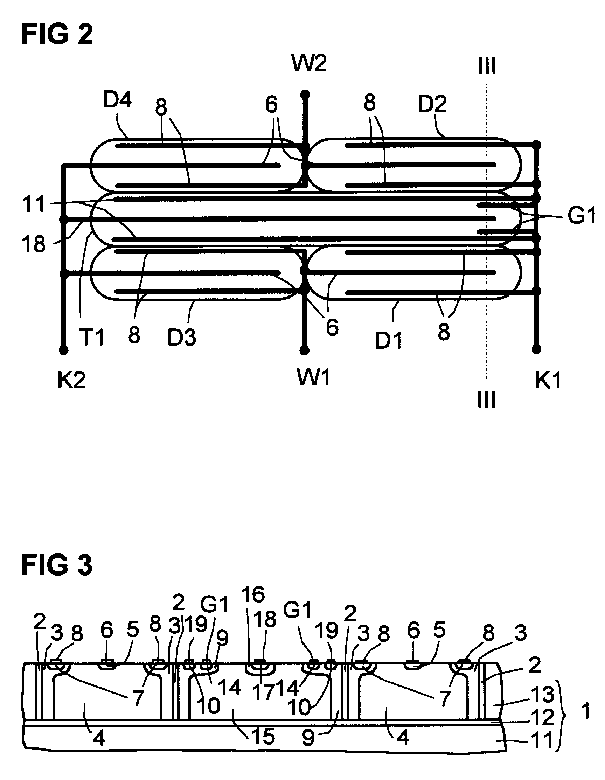

Die Schaltungsanordnung wird vorzugsweise in einem SOI-Substrat 1, das auf einer Siliziumscheibe 11 eine isolierende Schicht 12 und eine monokristalline Siliziumschicht 13 umfaßt (siehe Figur 3), integriert. Die isolierende Schicht 12 weist eine Dicke von zum Beispiel 3 µm auf und besteht aus SiO₂. Die Siliziumschicht 13 weist eine Dicke von zum Beispiel 20 µm auf und ist mit einer Dotierstoffkonzentration von 6 x 10¹⁴ cm-3 n-dotiert.

In der Siliziumschicht 13 sind die Dioden D1, D2, D3, D4 und der Thyristor T1 realisiert (siehe Aufsicht in Figur 2). Jedes der Bauelemente ist von einem isolierenden Graben 2 umgeben (siehe Figur 3). Der isolierende Graben 2 reicht jeweils bis auf die isolierende Schicht 12 und umgibt das jeweilige Bauelement vollständig.

Die Dioden umfassen jeweils ein p-dotiertes Gebiet 3, das an der Wand des zugehörigen, isolierenden Grabens 2 angeordnet ist und das von der Oberfläche der Siliziumschicht 13 bis zur Oberfläche der isolierenden Schicht 12 reicht (siehe Figur 3). Das p-dotierte Gebiet 3 weist eine Dotierstoffkonzentration von zum Beispiel 10¹⁷ cm⁻³ auf. Innerhalb des p-dotierten Gebietes 3 ist ein n⁻-dotiertes Gebiet 4 mit einer Dotierstoffkonzentration von zum Beispiel 6 x 10¹⁴ cm⁻³ angeordnet. Die Diode weist ferner ein n⁺-dotiertes Gebiet 5 auf, das eine Dotierstoffkonzentration von zum Beispiel 10²⁰ cm⁻³ aufweist und das an die Oberflache der Siliziumschicht 13 angrenzt. Auf der Oberflache des n⁺-dotierten Gebietes 5 ist ein Kathodenkontakt 6 angeordnet. Der Kathodenkontakt 6 besteht zum Beispiel aus Aluminium.

Das p-dotierte Gebiet 4, das die Diode entlang dem isolierenden Graben 2 vollständig umgibt, umfaßt ein ringförmiges p⁺-dotiertes Gebiet 7, das eine Dotierstoffkonzentration von zum Beispiel 10²⁰ cm⁻³ aufweist und das an die Oberfläche der Siliziumschicht 13 angrenzt. Auf der Oberfläche des p⁺-dotierten Gebietes 7 ist ein Anodenkontakt 8 aus zum Beispiel Aluminium angeordnet. Der Anodenkontakt 8 umfaßt zwei Streifen, die miteinander verbunden sind (siehe Aufsicht in Figur 2).

Der Thyristor T1 umfaßt ein p-dotiertes Gebiet 9, das entlang dem isolierenden Graben 2 angeordnet ist (siehe Figur 3). Das p-dotierte Gebiet 9 weist eine Dotierstoffkonzentration von zum Beispiel 10¹⁷ cm⁻³ auf. Das p-dotierte Gebiet 9 reicht von der Oberfläche der Siliziumschicht 13 bis auf die Oberflache der isolierenden Schicht 12. Das p-dotierte Gebiet 9 umgibt den Thyristor ringförmig.

In dem p-dotierten Gebiet 9 ist ein ringförmiges n⁺-dotiertes Gebiet 10 angeordnet, das eine Dotierstoffkonzentration von 10²⁰ cm⁻³ aufweist und das an die Oberfläche der Siliziumschicht 13 angrenzt. Auf der Oberflache des n⁺-dotierten Gebietes 19 ist ein Kathodenkontakt 19 aus zum Beispiel Aluminium angeordnet. Der Kathodenkontakt 19 umfaßt zwei streifenförmige Elemente, die miteinander verbunden sind (siehe Figur 2).

In dem p-dotierten Gebiet 9 ist ferner ein ringförmiges p⁺-dotiertes Gebiet 14 vorgesehen, das eine Dotierstoffkonzentration von 10²⁰ cm⁻³ aufweist und das an die Oberfläche der Siliziumschicht 13 angrenzt. Auf der Oberfläche des p⁺-dotierten Gebietes 14 ist die Gateelektrode G1 angeordnet. Das p⁺-dotierte Gebiet 14 ist als geschlossener Ring, der an die Oberfläche der Siliziumschicht 13 angrenzt, ausgebildet.

Innerhalb des p-dotierten Gebietes 9 umfaßt der Thyristor ein n⁻-dotiertes Gebiet 15, das eine Dotierstoffkonzentration von 6 x 10¹⁴ cm⁻³ aufweist. Innerhalb des n⁻-dotierten Gebietes 15 ist ein n-dotiertes Gebiet 16 angeordnet, das an die Oberfläche der Siliziumschicht 13 angrenzt und das eine Dotierstoffkonzentration von 10¹⁶ cm⁻³ aufweist.

Innerhalb des n-dotierten Gebietes 16 ist ein p⁺-dotiertes Gebiet 17 angeordnet, das eine Dotierstoffkonzentration von zum Beispiel 10²⁰ cm⁻³ aufweist und das an die Oberfläche der Siliziumschicht 13 angrenzt. Auf der Oberfläche des p⁺-dotierten Gebietes 17 ist ein Anodenkontakt 18 aus zum Beispiel Aluminium angeordnet. Der Anodenkontakt 18 verläuft streifenförmig über den Thyristor (siehe Figur 2).

Die Dotierstoffkonzentration des n⁻-dotierten Gebietes ist so eingestellt, daß bei sperrendem Zustand des Thyristors ein Teil des elektrischen Feldes in die isolierende Schicht 12 gedrängt wird. Dadurch weist der Thyristor T1 in Vorwärtspolung eine Sperrfähigkeit von 600 Volt auf. In Rückwärtspolung weist der Thyristor T1 eine Sperrfähigkeit von 200 Volt auf.

Zur Herstellung der Schaltungsanordnung wird vorzugsweise ein DWB-SOI-Substrat verwendet. In die Siliziumschicht 13 werden die die Bauelemente umgebenden Graben geätzt. Die Grabenwände werden mit einer Dotierstoffquelle, zum Beispiel dotiertem Glas oder dotiertem Polysilizium belegt, aus der das p-dotierte Gebiet 3 der Dioden und das p-dotierte Gebiet 9 des Thyristors ausdiffundiert werden. Nach Entfernen der Dotierstoffquelle werden die Gräben mit SiO₂ aufgefüllt. Anschließend werden die übrigen Diffusionsgebiete, Isolationsschichten (nicht dargestellt) und Kontakte in einem Planarprozeß erzeugt.

Anstelle des Thyristors kann die Schaltungsanordnung zwischen dem ersten Knoten K1 und dem zweiten Knoten K2 auch einen durch Steuerstrom abschaltbaren Thyristor (GTO), einen IGBT oder einen DMOS-Transistor umfassen.

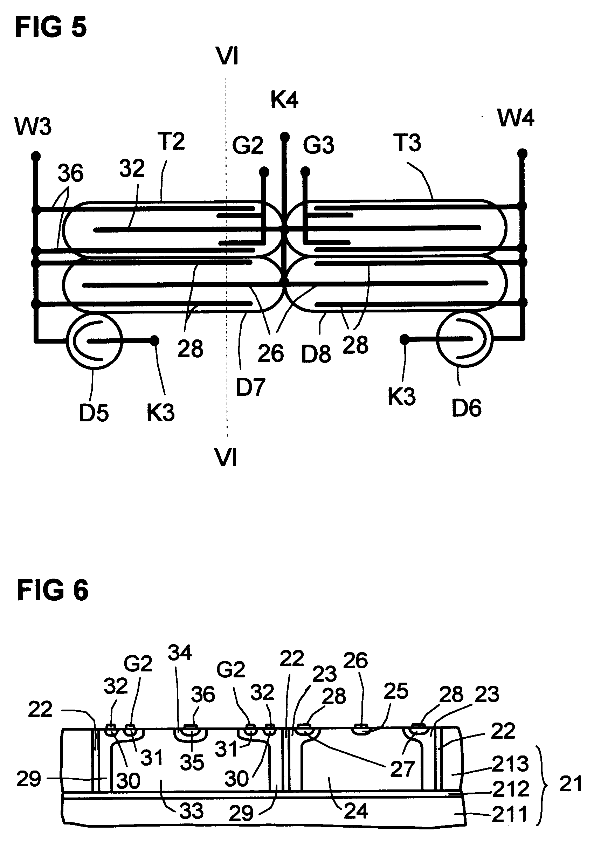

Eine zweite Ausführungsform einer integrierten Schaltungsanordnung, die die Funktion eines symmetrisch sperrenden Triacs emuliert, umfaßt zwischen einem ersten Knoten K3 und einem ersten Wechselspannungsanschluß W3 eine erste Diode D5 (siehe Figur 4). Die Kathode der ersten Diode D5 ist mit dem ersten Wechselspannungsanschluß W3 verbunden. Zwischen dem ersten Knoten K3 und einem zweiten Wechselspannungsanschluß W4 ist eine zweite Diode D6 so verschaltet, daß ihre Kathode mit dem zweiten Wechselspannungsanschluß W4 verbunden ist und daß somit die zweite Diode D6 entgegengesetzt gepolt zur ersten Diode D5 ist.

Zwischen dem ersten Wechselspannungsanschluß W3 und einem zweiten Knoten K4 ist eine dritte Diode D7 so verschaltet, daß ihre Kathode mit dem zweiten Knoten K4 verbunden ist. Zwischen dem zweiten Wechselspannungsanschluß W4 und dem zweiten Knoten K4 ist eine vierte Diode D8 so verschaltet, daß ihre Kathode mit dem zweiten Knoten K4 verbunden ist.

Antiparallel zur dritten Diode D4 ist zwischen dem ersten Wechselspannungsanschluß W3 und dem zweiten Knoten K4 ein erster Thyristor T2 verschaltet. Die Kathode des ersten Thyristors T2 ist mit dem ersten Wechselspannungsanschluß W3 verbunden, die Anode des Thyristors T2 ist mit dem zweiten Knoten K4 verbunden.

Antiparallel zu der vierten Diode D8 ist ein zweiter Thyristor T3 verschaltet, dessen Anode mit dem zweiten Knoten K4 und dessen Kathode mit dem ersten Wechselspannungsanschluß W4 verbunden ist. Der erste Thyristor T2 ist über eine Gateelektrode G2, der zweite Thyristor T3 ist über eine Gateelektrode G3 steuerbar.

Der erste Knoten K3 ist mit dem Substratpotential verbunden, das der Punkt mit dem negativsten Potential der Schaltung ist.

Der erste Wechselspannungsanschluß W3 und der zweite Wechselspannungsanschluß W4 werden mit einer Wechselspannungsquelle verbunden. In eine der Wechselspannungsleitungen wird ein Verbraucher V2 geschaltet.

Im Betrieb der Schaltungsanordnung werden die Gateelektroden G2, G3 jeweils von einer Ansteuerschaltung (nicht dargestellt) angesteuert. Im leitenden Zustand der Schaltungsanordnung fließt der Strom wahrend einer ersten Halbwelle über die vierte Diode D8 und den ersten Thyristor T2. Während einer zweiten Halbwelle fließt der Strom über die Diode D7 und den zweiten Thyristor T3. Der erste Thyristor T2 und der zweite Thyristor T3 werden dabei jeweils in der Polung von Kathode zu Anode vom Strom durchflossen.

Die Kathoden der Thyristoren T2, T3 liegen auf einem positiven Potential gegenüber dem Substrat. Dasselbe Potential wird für die Ansteuerung der Gateelektroden G2, G3 verwendet, die über eine Ansteuerschaltung (nicht dargestellt) erfolgt. Die Versorgungsspannung für die Ansteuerschaltung kann aus den Knoten K3, K4 abgeleitet werden.

Über die erste Diode D5 und die zweite Diode D6 wird das Substratpotential festgelegt. Der Nutzstrom fließt in dieser Schaltungsanordnung über die dritte Diode D7, den zweiten Thyristor T3, die vierte Diode D8 und den ersten Thyristor T2. Daher können die erste Diode D5 und die zweite Diode D6 kleiner dimensioniert werden als die dritte Diode D7 und die vierte Diode D8. Vorzugsweise werden die erste Diode D5 und die zweite Diode D6 so dimensioniert, daß sie den durch die Verschiebungsströme zum Umpolen der Substratspannung verursachten Verlusten standhalten.. Die dritte Diode D7 und die vierte Diode D8 sowie der erste Thyristor T2 und der zweite Thyristor T3 werden so dimensioniert, daß sie jeweils den Verlusten bei Stromfluß wahrend jeder zweiten Wechselstromhalbwelle standhalten.

Vorzugsweise wird die Schaltungsanordnung in einem SOI-Substrat 21, das eine Siliziumscheibe 211, eine darauf angeordnete isolierende Schicht 212 aus SiO₂ und eine darauf angeordnete monokristalline Siliziumschicht 213 umfaßt, integriert (siehe Figur 6). Die Dioden D5, D6, D7, D8 sowie die Thyristoren T2, T3 sind in der Siliziumschicht 213 realisiert. Jedes der Bauelemente ist dabei von einem isolierenden Graben 22 umgeben, der von der Oberflache der Siliziumschicht 213 bis auf die Oberflache der isolierenden Schicht 212 reicht und der das jeweilige Bauelement vollständig ringförmig umgibt. Die isolierenden Graben 22 sind zum Beispiel mit SiO₂ gefüllt.

Die Dioden umfassen jeweils ein p-dotiertes Gebiet 23, das entlang der Seitenwand des zugehörigen Grabens 22 angeordnet ist. Das p-dotierte Gebiet 23 reicht von der Oberfläche der Siliziumschicht 213 bis auf die Oberfläche der isolierenden Schicht 212 und umgibt die Diode vollständig. Das p-dotierte Gebiet 23 weist eine Dotierstoffkonzentration von zum Beispiel 10¹⁷ cm⁻³ auf. Innerhalb des p-dotierten Gebietes 23 ist ein n⁻-dotiertes Gebiet 24 angeordnet, das eine Dotierstoffkonzentration von zum Beispiel 6 x10¹⁴ cm⁻³ aufweist. Innerhalb des n⁻-dotierten Gebietes 24 ist ein n⁺-dotiertes Gebiet 25 mit einer Dotierstoffkonzentration von zum Beispiel 10²⁰ cm⁻³ angeordnet, das an die Oberflache der Siliziumschicht 213 angrenzt. Auf der Oberfläche des n⁺-dotierten Gebietes 25 ist ein Kathodenkontakt 26 aus zum Beispiel Aluminium angeordnet. Der Kathodenkontakt 26 verläuft streifenförmig über die Diode (vergleiche Aufsicht in Figur 5).

Innerhalb des p-dotierten Gebietes 23 ist ein p⁺-dotiertes Gebiet 27 angeordnet, das ringförmig ausgebildet ist und das an die Oberfläche der Siliziumschicht 213 angrenzt (siehe Figur 6). Das p⁺-dotierte Gebiet 27 weist eine Dotierstoffkonzentration von 10²⁰ cm⁻³ auf. Auf der Oberfläche des p⁺-dotierten Gebietes 27 ist ein Anodenkontakt 28 aus zum Beispiel Aluminium angeordnet. Der Anodenkontakt 28 umfaßt zwei streifenförmige Elemente, die miteinander verbunden sind (vergleiche Aufsicht in Figur 5).

Die Thyristoren umfassen jeweils ein p-dotiertes Gebiet 29, das entlang der Seitenwand des zugehörigen isolierenden Grabens 22 angeordnet ist (siehe Figur 6). Das p-dotierte Gebiet 29 reicht von der Oberfläche der Siliziumschicht 213 bis auf die Oberfläche der isolierenden Schicht 212 und umgibt den Thyristor ringförmig. Innerhalb des p-dotierten Gebietes 29 ist ein n⁺-dotiertes Gebiet 30 mit einer Dotierstoffkonzentration von 10²⁰ cm⁻³ angeordnet, das an die Oberfläche der Siliziumschicht 213 angrenzt und das ringförmig ausgebildet ist. Ferner ist in dem p-dotierten Gebiet 9 ein p⁺-dotiertes Gebiet 31 mit einer Dotierstoffkonzentration von zum Beispiel 10²⁰ cm⁻³ angeordnet, das an die Oberfläche der Siliziumschicht 213 angrenzt und das ringförmig ausgebildet ist.

An der Oberfläche des n⁺-dotierten Gebietes 30 ist ein Kathodenkontakt 32 aus zum Beispiel Aluminium angeordnet. Der Kathodenkontakt 32 umfaßt zwei streifenförmige Elemente, die miteinander verbunden sind (vergleiche Aufsicht in Figur 5).

Auf der Oberfläche des p⁺-dotierten Gebietes 31 ist die Gateelektrode G2 angeordnet (siehe Figur 6).

Innerhalb des p-dotierten Gebietes 29 ist ein n⁻-dotiertes Gebiet 33 mit einer Dotierstoffkonzentration von 6 x10¹⁴ cm⁻³ angeordnet. Das n⁻-dotierte Gebiet 33 umfaßt ein n-dotiertes Gebiet 34 mit einer Dotierstoffkonzentration von 10¹⁶ cm⁻³, das an die Oberfläche der Siliziumschicht 213 angrenzt. In dem n-dotierten Gebiet 34 ist ein p⁺-dotiertes Gebiet 35 angeordnet, das an die Oberfläche der Siliziumschicht 213 angrenzt. Auf der Oberfläche des p⁺-dotierten Gebietes 35 ist ein Anodenkontakt 36 aus zum Beispiel Aluminium angeordnet. Der Anodenkontakt 36 verläuft streifenförmig über den Thyristor (siehe Figur 5).

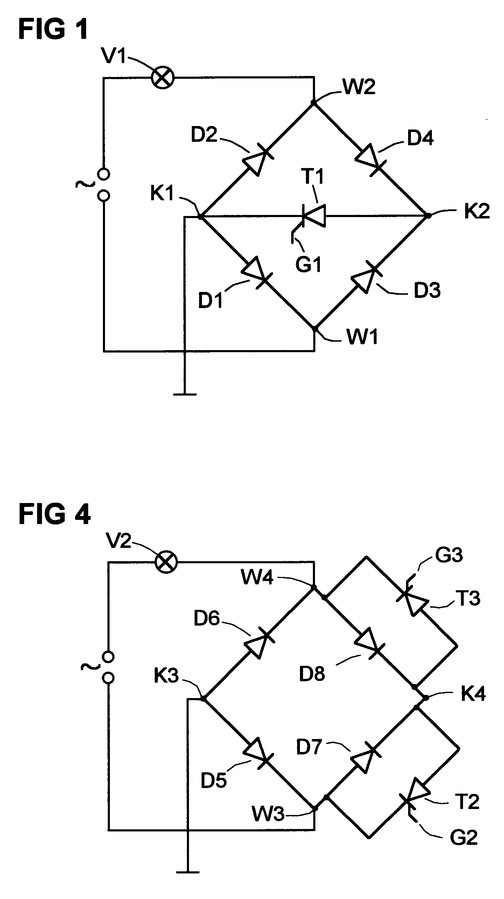

Die Herstellung der anhand von Figur 4 bis Figur 6 erläuterten Schaltungsanordnung erfolgt analog der Herstellung der anhand von Figur 1 bis 3 erläuterten Schaltungsanordnung.

Die Dotierstoffkonzentration des n⁻-dotierten Gebietes 33 bewirkt, daß im sperrenden Zustand des Thyristors ein Teil des elektrischen Feldes in die isolierende Schicht 212 gedrängt wird. Dadurch weist der Thyristor in Vorwärtsrichtung eine Sperrfähigkeit von 600 Volt, in Rückwärtsrichtung eine Sperrfähigkeit von 200 Volt auf.

Anstelle der Thyristoren T2, T3 können auch durch Steuerstrom abschaltbare Thyristoren (GTO), IGBT oder DMOS-Transistoren verwendet werden.

Wird anstelle der Thyristoren T2, T3 jeweils ein DMOS-Transistor verwendet, so liegt es im Rahmen der Erfindung, daß jeweils dessen interne Diode die Funktion der antiparallelen dritten Diode D7 bzw. vierten Diode D8 übernimmt. In diesem Fall kann auf die dritte Diode D7 und die vierte Diode D8 verzichtet werden.

## Patentansprüche

1. Integrierte Schaltungsanordnung,
- bei der zwei Wechselspannungsanschlüsse (W1, W2) vorgesehen sind,
- bei der ein erster Schaltungszweig (D3, T1, D2) und ein zweiter Schaltungszweig (D4, T1, D1)vorgesehen sind, die jeweils zwischen den Wechselspannungsanschlüssen (W1, W2) verschaltet sind und die jeweils mindestens eine Diode (D1) und ein asymmetrisch sperrendes, ansteuerbares Leistungsbauelement (T1) umfassen, wobei im leitenden Zustand des ansteuerbaren Leistungsbauelementes (T1) der Strom in einer ersten Halbwelle der Wechselspannung über den ersten Schaltungszweig (D4, T1, D1) und in einer zweiten Halbwelle der Wechselspannung über den zweiten Schaltungszweig (D3, T1, D2) fließt und wobei der Strom das ansteuerbare Leistungsbauelement (T1) in der Richtung der höheren Sperrfähigkeit durchfließt,
- bei der die ansteuerbaren Leistungsbauelemente in einem SOI-Wafer realisiert sind, der ein Siliziumsubstrat, eine darauf angeordnete, vergrabene Isolationsschicht und eine darauf angeordnete, aktive Siliziumschicht umfaßt,
- bei der die ansteuerbaren Leistungsbauelemente und die Dioden in der aktiven Siliziumschicht integriert enthalten sind,
- bei der die ansteuerbaren Leistungsbauelemente und die Dioden in vertikaler Richtung durch die vergrabene Isolationsschicht isoliert sind,
- bei der jedes der ansteuerbaren Leistungsbauelemente und der Dioden in lateraler Richtung durch einen es umgebenden, isolierenden Graben, der bis auf die isolierende Schicht reicht, isoliert ist,
- bei der die Dotierstoffkonzentration in der aktiven Siliziumschicht so eingestellt ist, daß im sperrenden Zustand des ansteuerbaren Leistungsbauelementes ein Teil des elektrischen Feldes in die vergrabene Isolationsschicht gedrangt wird.

2. Schaltungsanordnung nach Anspruch 1,
- bei der eine erste Diode (D1) zwischen einen ersten Knoten (K1) und einen ersten Wechselspannungsanschluß (W1) verschaltet ist,
- bei der eine zweite Diode (D2) entgegensetzt gepolt zur ersten Diode (D1) zwischen den ersten Knoten (K1) und einen zweiten Wechselspannungsanschluß (W2) verschaltet ist,
- bei der eine dritte Diode (D3) zwischen den ersten Wechselspannungsanschluß (W1) und einen zweiten Knoten (K2) verschaltet ist,
- bei der eine vierte Diode (D4) entgegengesetzt gepolt zur dritten Diode (D3) zwischen den zweiten Wechselspannungsanschluß (W2) und den zweiten Knoten (K2) verschaltet ist,
- bei der ein ansteuerbares Leistungsbauelement (T1) zwischen den ersten Knoten (K1) und den zweiten Knoten (K2) verschaltet ist,
- bei der der erste Schaltungszweig die erste Diode (D1), das Leistungsbauelement (T1) und die vierte Diode (D4) umfaßt, wobei die erste Diode (D1) und die vierte Diode (D4) in gleicher Richtung gepolt sind,
- bei der der zweite Schaltungszweig die zweite Diode (D2), das Leistungsbauelement (T1) und die dritte Diode (D3) umfaßt, wobei die zweite Diode (D2) und die dritte Diode (D3) in gleicher Richtung gepolt sind.

3. Schaltungsanordnung nach Anspruch 1,
- bei der eine erste Diode (D5) zwischen einen ersten Knoten (K3) und einen ersten Wechselspannungsanschluß (W3) verschaltet ist,
- bei der eine zweite Diode (D6) entgegengesetzt gepolt zu der ersten Diode (D5) zwischen den ersten Knoten (K3) und einen zweiten Wechselspannungsanschluß (W4) verschaltet ist,
- bei der eine dritte Diode (D7) zwischen den ersten Wechselspannungsanschluß (W3) und einen zweiten Knoten (K4) verschaltet ist,
- bei der ein erstes ansteuerbares Leistungsbauelement (T2) antiparallel zu der dritten Diode (D7) zwischen den ersten Wechselspannungsanschluß (W3) und den zweiten Knoten (K4) verschaltet ist,
- bei der eine vierte Diode (D8) entgegengesetzt gepolt zur dritten Diode (D7) zwischen den zweiten Knoten (K4) und den zweiten Wechselspannungsanschluß (W4) verschaltet ist,
- bei der ein zweites ansteuerbares Leistungsbauelement (T3) antiparallel zu der vierten Diode (D8) zwischen den zweiten Knoten (K4) und den zweiten Wechselspannungsanschluß (W4) verschaltet ist,
- bei der der erste Schaltungszweig das erste ansteuerbare Leistungsbauelement (T2) und die vierte Diode (D8) umfaßt,
- bei der der zweite Schaltungszweig das zweite ansteuerbare Leistungsbauelement (T3) und die dritte Diode (D7) umfaßt.

4. Schaltungsanordnung nach Anspruch 3,
bei der das erste ansteuerbare Leistungsbauelement und die antiparallele dritte Diode sowie das zweite ansteuerbare Leistungsbauelement und die antiparallele vierte Diode jeweils durch einen DMOS-Transistor und dessen interne Diode realisiert sind.

5. Schaltungsordnung nach einem der Ansprüche 1 bis 3,
bei der das oder die ansteuerbaren Leistungsbauelement als Thyristor, GTO, IGBT oder DMOS-Transistor realisiert sind.
